Europäisches Patentamt

European Patent Office

Office européen des brevets

(19)

(11) Numéro de publication: **0 016 695**
**B1**

(12) **FASCICULE DE BREVET EUROPEEN**

(45) Date de publication du fascicule du brevet: **04.01.84**

(51) Int. Cl.³: **H 03 D 9/06, H 04 B 1/26**

(21) Numéro de dépôt: **80400339.0**

(22) Date de dépôt: **14.03.80**

(54) **Mélangeur symétrique pour ondes millimétriques et récepteur utilisant un tel mélangeur.**

(30) Priorité: **23.03.79 FR 7907386**

(43) Date de publication de la demande:
**01.10.80 Bulletin 80/20**

(45) Mention de la délivrance du brevet:
**04.01.84 Bulletin 84/1**

(84) Etats contractants désignés:
**DE GB IT NL**

(73) Titulaire: **THOMSON-CSF**
**173, Boulevard Haussmann**
**F-75379 Paris Cedex 08 (FR)**

(72) Inventeur: **Cachier, Gérard**
**"THOMSON-CSF" CSPI - 173, bld Haussmann**
**F-75360 Paris Cedex 08 (FR)**

(74) Mandataire: **Lepercque, Jean et al,**
**THOMSON-CSF SCPI 173, Bld Haussmann**
**F-75379 Paris Cedex 08 (FR)**

(56) Documents cités:
**EP - A - 0 012 730**
**DE - B - 1 137 486**
**DE - B - 1 183 553**
**US - A - 2 576 481**
**US - A - 3 842 359**

**IEEE TRANSACTIONS ON MICROWAVE
THEORY AND TECHNIQUES, vol. MTT-24, no. 1,
janvier 1976 NEW YORK (US) A. HISLOP et al.:
"A broad-band 40-60-GHz balanced mixer",
pages 63-64**

(56) Documents cités:
**IEEE INTERNATIONAL SOLID STATE CIRCUITS
CONFERENCE, vol. 22, février 1979 NEW YORK
(US) G. CACHIER et al.: "Modular techniques for
controlling the frequency of millimeter
IMPATTS", pages 170, 171**

Courier Press, Leamington Spa, England.

Mélangeur symétrique pour ondes millimétriques et récepteur utilisant un tel mélangeur.

L'invention concerne un mélangeur symétrique utilisable pour le changement de fréquence en ondes millimétriques et un récepteur radioélectrique hyperfréquence utilisant un tel mélangeur.

En hyperfréquence, un mélangeur symétrique comporte deux diodes détectrices, par exemple deux diodes Schottky, recevant chacune à la fois le signal à traiter et la fréquence d'un oscillateur local. On s'arrange pour que les signaux de sortie des deux diodes, à la fréquence, dite intermédiaire, du récepteur s'ajoutent entre eux, tandis que les variations d'amplitude (bruit d'amplitude provenant des irrégularités de l'oscillateur local) se soustraient, ce qui permet de compenser ce défaut.

De tels mélangeurs sont connus en particulier par l'article "A broad-band 40—60 GHz balanced mixer" publié par A. HISLOP et al. dans IEEE TRANSACTIONS ON MICROWAVE THEORY AND TECHNIQUES de janvier 76, volume 24 n° 1, pages 63 et 64, dont l'enseignement constitue le préambule de la revendication 1.

Il est connu que de tels mélangeurs sont électriquement fragiles compte tenu de la fonction assurée et de l'implantation géographique qui en découle. En effet, ces dispositifs sont placés près de la source, en général une antenne, et sont soumis à toutes les surcharges d'origine atmosphérique (orages) ou industrielle (parasites). Ces diodes sont d'autant plus fragiles qu'elles sont petites et qu'elles présentent une impédance élevée; en effet une faible énergie parasite développe aux bornes d'une diode de grande impédance une tension élevée qui peut être destructrice.

— les mélangeurs proposés se prêtent mal à un changement rapide des semiconducteurs en cas de destructions.

— les mélangeurs connus manquent de simplicité industrielle.

— l'accès au signal de sortie et la polarisation électrique des diodes mettent en oeuvre des moyens complexes et fragiles.

L'invention propose une structure qui permet de pallier ces inconvénients notamment en plaçant les diodes sur des modules facilement interchangeables permettant la réalisation d'un dispositif industriel simple avec une solution robuste pour l'accès au signal de sortie et l'application du signal de polarisation aux diodes.

Des modules sont connus en soi pour des applications à des oscillateurs et ont été décrits dans l'article "Modular techniques for controlling the frequency of millimeter IMPATTS" publié par G. CACHIER et al. dans IEE INTERNATIONAL SOLID STATE CIRCUITS CONFERENCE de février 1979, volume 22, pages 170 et 171.

L'invention a donc pour objet un mélangeur symétrique pour ondes millimétriques du type comportant deux diodes semiconductrices disposées face à face dans un champ électromagnétique représentant le signal à traiter, une lame de circuit imprimé comprenant une couche de matériau diélectrique comportant des métallisations disposées de part et d'autre de celle-ci, chaque métallisation étant en contact électrique avec une première électrode de l'une des diodes semiconductrices, lesdites métallisations étant disposées perpendiculairement au vecteur représentatif de la composante électrique du champ électromagnétique du signal à traiter, un premier guide d'onde dans lequel se propage une première onde électromagnétique correspondant au signal à traiter, un second guide d'onde solidaire du premier et parallèle à ce dernier dans lequel se propage une seconde onde électromagnétique correspondant à un signal local dont la composante électrique est orientée de façon à exciter une extrémité desdites métallisations introduites dans ce second guide par une fenêtre débouchant dans le premier guide, caractérisé en ce que l'autre extrémité de la lame en circuit imprimé est accessible de l'extérieur après avoir traversé une seconde fenêtre réalisée dans une paroi du premier guide permettant d'accéder aux métallisations par une paire de bornes en vue de recueillir le signal de sortie et d'appliquer un signal de polarisation aux diodes et en ce que chacune des diodes semiconductrices est intégrée dans un module, chaque module comprenant un support conducteur en contact avec la seconde électrode de cette diode, une couche de matériau diélectrique placée sur ce support en entourant la diode et une métallisation déposée sur cette couche et en contact électrique avec la première électrode de la diode et l'une desdites métallisations, les deux modules étant disposés tête-bêche dans le premier guide d'onde, de telle sorte que le plan de symétrie des modules soit perpendiculaire à ladite composante électrique de la première onde électromagnétique et la lame de circuit imprimé comprise dans ce plan de symétrie.

L'invention a encore pour objet un récepteur pour ondes millimétriques comportant un mélangeur selon les revendications 1 à 2.

L'invention sera mieux comprise, et d'autres caractéristiques apparaîtront, au moyen de la description qui suit et des dessins qui l'accompagnent, parmi lesquels:

— les figures 1 et 2 représentent suivant deux coupes orthogonales un exemple de réalisation de mélangeur symétrique selon l'invention;

— les figures 3 et 4 représentent schématiquement des variantes de l'invention.

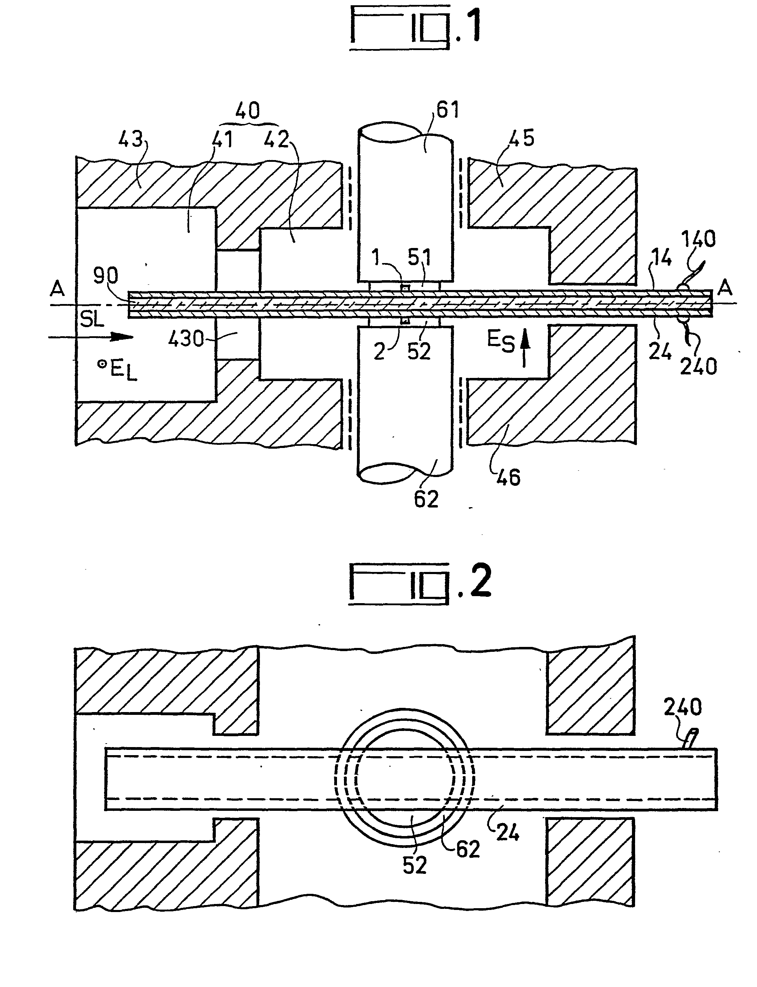

Les diodes 1 et 2 sont représentées en coupe figure 1 comme faisant partie chacune d'un module; les modules sont disposés tête-bêche sur un axe commun. Chaque module comporte un support conducteur de la chaleur et de l'électricité, 61 ou 62, un dépôt 51 ou 52 de matériau diélectrique entourant la diode et une métallisation non représentée sur la figure recouvrant l'autre électrode de la diode ainsi que la surface libre du dépôt 51. Les diodes sont par exemple du type Schottky, celles-ci étant soudées du côté de la jonction métal-semiconducteur au support 61 ou 62.

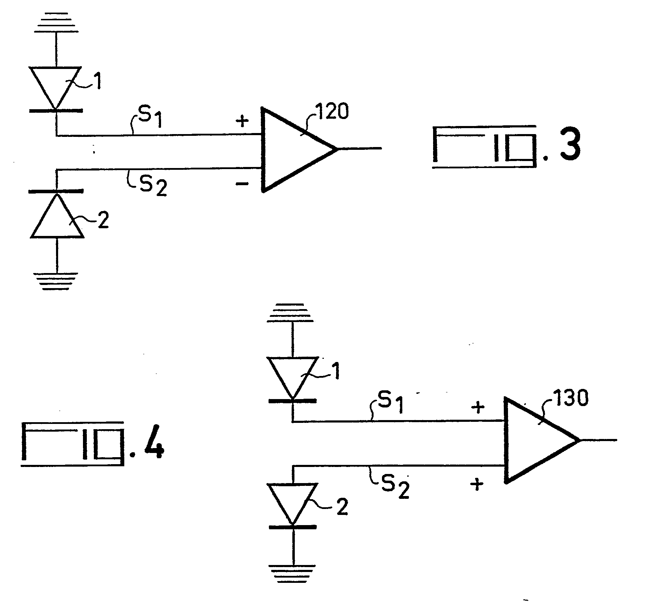

La figure 1 est une coupe d'un mélangeur 40 comportant deux cavités 41 et 42 ayant une paroi commune 43. Le même mélangeur est représenté figure 2 suivant un plan de coupe de trace AA figure 1. Les deux modules sont mis en place dans la cavité 42 où les supports 61 et 62 pénètrent par des taraudages pratiqués dans les paroi 45 et 46 de cette cavité. On a disposé, entre les modules, un organe de couplage constitué par deux bandes conductrices 14 et 24, recouvrant chacune une très grande partie de chaque face d'une feuille de diélectrique 90. Ces bandes cumulent les fonctions d'alimentation des diodes en courant continu, celles de sorties en haute fréquence, enfin celles d'organe de couplage avec les champs électromagnétiques $E_L$ et $E_s$.

Figure 1 on aperçoit les conducteurs 14 et 24 avec leurs connexions 140 et 240; figure 2 on aperçoit seulement la feuille 90 et, sous le diélectrique, la représentation en pointillé du conducteur 24, ainsi qu'une portion de connexion 240.

Le fonctionnement du mélangeur est le suivant: la composante électrique $E_L$ induit un courant de haute fréquence dans la lame métallisée 90. Cette lame rayonne à son tour un champ électromagnétique présentant des composantes électriques symétriques $E_1$ et $E_2$ par rapport au plan de la lame 90. L'ensemble des modules tête-bêche est disposé dans un champ électromagnétique dont la composante $E_s$ est parallèle à l'axe de ces modules. Cette composante est détectée par les diodes tête-bêche en donnant des signaux en opposition de phase alors que les composantes $E_1$ et $E_2$ donnent des signaux détectés en phase. Les signaux de battement qui en résultent dans les deux diodes apparaissent en opposition de phase sur les sorties 140 et 240. De tels signaux sont utilisables de façon classique par un amplificateur différentiel pour former un signal de réception dans lequel le bruit dû aux variations d'amplitude de l'oscillateur local est éliminé en très grande partie. Les signaux peuvent aussi être additionnés algébriquement au moyen d'un dispositif passif, puis amplifiés.

Figures 3 et 4, on a représenté de façon symbolique, deux types de mélangeurs selon l'invention. Dans le premier type, figure 3, qui est celui de l'exemple précédent, les diodes 1 et 2 sont tête-bêche. Les sorties $S_1$ et $S_2$ des signaux détectés en fréquence intermédiaire sont connectées sur les deux entrées d'un amplificateur différentiel 120. On n'a pas représenté les connexions de polarisation.

Dans le second type de mélangeur, figure 4, les diodes 1 et 2 sont disposées dans le même sens par rapport au champ électrique du signal $E_s$, c'est-à-dire qu'elles ne sont plus tête-bêche. Les sorties $S_1$ et $S_2$ de fréquence intermédiaire sont reliées aux entrées symétriques d'un amplificateur opérationnel 130 qui effectue la moyenne des deux signaux. Une particularité avantageuse de ce type de montage provient de ce que l'on peut réunir les deux sorties sur un seul fil de connexion.

L'invention est applicable à un récepteur pour ondes millimétriques. L'oscillateur local de ce récepteur débitera dans un guide d'ondes couplé par les moyens décrits ci-avant à un guide d'ondes recevant le signal à traiter en provenance de l'antenne du récepteur.

**Revendications**

1. Mélangeur symétrique pour ondes millimétriques du type comportant deux diodes semiconductrices (1, 2) disposées face à face dans un champ électromagnétique représentant le signal à traiter, une lame de circuit imprimé comprenant une couche de matériau diélectrique (90) comportant des métallisations (14, 24) disposées de part et d'autre de celle-ci, chaque métallisation étant en contact électrique avec une première électrode de l'une des diodes semiconductrices (1, 2), lesdites métallisations (14, 24) étant disposées perpendiculairement au vecteur (Es) représentatif de la composante électrique du champ électromagnétique du signal à traiter, un premier guide d'onde (42) dans lequel se propage une première onde électromagnétique correspondant au signal à traiter, un second guide d'onde (41) solidaire du premier et parallèle à ce dernier dans lequel se propage une seconde onde électromagnétique correspondant à un signal local dont la composante électrique est orientée de façon à exciter une extrémité desdites métallisations (14, 24) introduites dans ce second guide (41) par une fenêtre (430) débouchant dans le premier guide (42), caractérisé en ce que l'autre extrémité de la lame en circuit imprimé est accessible de l'extérieur après avoir traversé une seconde fenêtre réalisée dans une paroi du premier guide (42) permettant d'accéder aux métallisations (14, 24) par une paire de bornes (140, 240) en vue de recueillir le signal de sortie et d'appliquer un signal de polarisation aux diodes (1, 2) et en ce que chacune des diodes semiconductrices (1, 2) est intégrée dans un module, chaque module comprenant un support conducteur (61, 62) en contact avec la seconde électrode de cette diode, une couche de matériau diélectrique (51, 52) placée sur ce support en entourant la diode (1, 2) et une métallisation déposée sur cette couche et en contact électrique avec la première électrode de la diode et l'une desdites métallisations (14, 24), les deux modules étant

**5**     **0 016 695**     **6**

disposés tête-bêche dans le premier guide d'onde (42), de telle sorte que le plan de symétrie des modules soit perpendiculaire à ladite composante électrique de la première onde électromagnétique et la lame de circuit imprimé (90, 14, 24) comprise dans ce plan de symétrie.

2. Mélangeur symétrique suivant la revendication 1, caractérisé en ce que les diodes (1, 2) sont disposées de façon inverse dans les deux modules (figure 4), la cathode de l'une (2) et l'anode de l'autre (1) étant reliées à la masse, tandis que l'anode de l'une (2) et la cathode de l'autre (1) sont reliées ($S_1$, $S_2$) aux entrées d'un amplificateur opérationnel (130).

3. Récepteur pour ondes millimétriques caractérisé en ce qu'il comporte un mélangeur réalisé selon l'une des revendications 1 ou 2.

**Patentansprüche**

1. Symmetrischer Mischer für Millimeterwellen, mit zwei Halbleiterdioden (1, 2), die einander zugewendet in einem elektromagnetischen Feld angeordnet sind, welches das zu verarbeitende Signal darstellt, einer gedruckten Schaltungsplatte, die eine Schicht aus dielektrischem Material (90) umfaßt, die auf beiden Seiten derselben angeordnete Metallisierungen (14, 24) umfaßt, wobei jede Metallisierung elektrisch mit einer ersten Elektrode einer der Halbleiterdioden (1, 2) in Berührung ist, wobei die genannten Metallisierungen (14, 24) senkrecht zu dem Vektor(Es) angeordnet sind, welcher die elektrische Komponente des elektromagnetischen Feldes des zu verarbeitenden Signals darstellt, mit einem ersten Wellenleiter (42), in welchem sich eine erste elektromagnetische Welle ausbreitet, die dem zu verarbeitenden Signal entspricht, mit einem zweiten Wellenleiter (41), der mit dem ersten fest verbunden und parallel zu diesem ist und in welchem sich eine zweite elektromagnetische Welle ausbreitet, die einem Lokalsignal entspricht, dessen elektrische Komponente so orientiert ist, daß ein Ende der genannten Metallisierungen (14, 24) erregt wird, die in diesen zweiten Wellenleiter (41) durch ein Fenster (430) hindurch eingeführt sind, das in den ersten Wellenleiter (42) einmündet, dadurch gekennzeichnet, daß das andere Ende der gedruckten Schaltungsplatte von der Außenseite her zugänglich ist, nachdem ein zweites Fenster durchquert wurde, das in einer Wandung des ersten Wellenleiters (42) gebildet ist und Zugang zu den Mellisierungen (14, 24) über ein erstes Anschlußpaar (140, 240) gestattet, um das Ausgangssignal abzunehmen und ein Polarisationssignal an die Dioden (1, 2) anzulegen, und daß jede der Halbleiterdioden (1, 2) in einen Modul integriert ist, wobei jeder Modul einen leitenden Träger (61, 62), der mit der zweiten Elektrode dieser Diode in Kontakt ist, eine Schicht aus dielektrischem Material (51, 52) die auf diesem Träger angeordnet ist und die Diode (1, 2) umgibt, und eine Metallisierung umfaßt, welche auf dieser Schicht aufgebracht ist und in elektrischem Kontakt mit der ersten Elektrode der Diode und einer der genannten Metalliesierungen (14, 24) ist, wobei die zwei Moduln in dem ersten Wellenleiter (42) in zueinander entgegengesetzter Lage so angeordnet sind, daß die Symmetrieebene der Moduln senkrecht zu der elektrischen Komponente der ersten elektromagnetischen Welle und der in dieser Symmetrieebene liegenden gedruckten Schaltungsplatte (90, 14, 24) ist.

2. Symmetrischer Mischer nach Anspruch 1, dadurch gekennzeichnet, daß die Dioden (1, 2) in den zwei Moduln einander entgegengesetzt angeordnet sind (Fig. 4), wobei die Kathode der einen (2) und die Anode der anderen (1) mit Masse verbunden sind, während die Anode der einen (2) und die Kathode der anderen (1) mit den Eingängen eines Operationsverstärkers (130) verbunden ($S_1$, $S_2$) sind.

3. Millimeterwellenempfänger, dadurch gekennzeichnet, daß er einen Mischer nach Anspruch 1 oder 2 enthält.

**Claims**

1. Symmetric mixer for millimeter waves, of the type comprising two semiconductor diodes (1, 2) arranged in facing relationship within an electro-magnetic field representing the signal to be processed, a printed circuit sheet comprising a layer of dielectric material (90) comprising metallizations (14, 24) located on both sides thereof, each metallization being in electrical contact with a first electrode of one of the semiconductor diodes (1, 2), said metallizations (14, 24) being perpendicular to the vector (Es) representing the electrical component of the electro-magnetic field of the signal to be processed, a first waveguide (42) wherein a first electro-magnetic wave propagates which corresponds to the signal to be processed, a second waveguide (41) joining the first and parallel thereto, and wherein a second electro-magnetic wave propagates which corresponds to a local signal the electrical component of which is oriented in a manner to excite one end of said metallizations (14, 24) introduced into this second guide (41) through a window (430) opening into the first guide (42), characterized in that the other end of the printed circuit sheet is accessible from outside after having passed through a second window formed within a wall of the first guide (42) allowing access to the metallizations (14, 24) through a pair of terminals (140, 240) in order to collect the output signal and to apply a polarization signal to the diodes (1, 2), and in that each of the semiconductor diodes (1, 2) is integrated into a module, each module comprising a conductor carrier (61, 62) contacting the second electrode of this diode, a layer of dielectric material (51, 52) placed onto this carrier and surrounding the diode (1, 2), and a metal-

4

lization deposited on said layer and electrically contacting the first electrode of the diode and one of said metallizations (14, 24), the two modules being arranged in mutually inverted positions within the first waveguide (42) in such a manner that the symmetry plane of the modules is perpendicular to said electrical component of the first electro-magnetic wave and the printed circuit sheet (90, 14, 24) comprised within this symmetry plane.

2. Symmetric mixer according to claim 1, characterized in that the diodes (1, 2) are arranged in mutually inverted manner within the two modules (Fig. 4), the cathode of one (2) and the anode of the other (1) being connected to ground while the anode of one (2) and the cathode of the other (1) are connected ($S_1$, $S_2$) to the inputs of an operational amplifier (130).

3. Millimeter wave receiver, characterized in that it comprises a mixer according to any of claims 1 or 2.

**0016695**

1

0 016 695

FIG.3

FIG.4